# EUROPEAN PATENT APPLICATION

(11) **EP 4 832 462 A1**
(43) Date of publication of application: **28.10.2026**
(21) Application number: 25890801.1
(22) Date of filing: 22.07.2025
(51) Int. Cl.: H04M 1/02, G06F 1/16, H05K 7/14, H05K 5/02

(54) **FOLDABLE ELECTRONIC DEVICE, AND BENDING STRUCTURE**

(30) Priority: 13.11.2024 CN 202422783149 U
(71) Applicant: Huawei Technologies Co., Ltd., Shenzhen, Guangdong 518129 (CN)
(72) Inventor: HU, Hanzi, Shenzhen, Guangdong 518129 (CN); YOU, Yulin, Shenzhen, Guangdong 518129 (CN); WU, Shengyin, Shenzhen, Guangdong 518129 (CN); ZHANG, Hui, Shenzhen, Guangdong 518129 (CN); SUN, Yu, Shenzhen, Guangdong 518129 (CN); GUO, Chao, Shenzhen, Guangdong 518129 (CN)
(74) Representative: Gill Jennings & Every LLP
(86) International application number: PCT/CN2025/109827
(87) International publication number: WO 2026/103206

(57) **Abstract**

This application provides a foldable electronic device and a bending structure. The foldable electronic device includes a flexible circuit board, a hinge mechanism, a first middle frame, and a second middle frame. The flexible circuit board may penetrate the hinge mechanism in a first direction, so that a part of the flexible circuit board is located inside the hinge mechanism. The first middle frame and the second middle frame are respectively located on two sides of the hinge mechanism in the first direction, and the first middle frame and the second middle frame are respectively rotatably connected to the hinge mechanism. In this application, a thickness of the first middle frame is reduced to a specific extent by changing a fitting relationship between the first middle frame and the first press-fitting support, so that the first middle frame has a step structure. This facilitates lap joint between a first connection part of the first press-fitting support and the first middle frame, reduces a thickness size of the foldable electronic device in a second direction, and further implements a trend of reducing an overall thickness of the foldable electronic device.

## Description

This application claims priority to Chinese Patent Application No. 202422783149.3, filed with the China National Intellectual Property Administration on November 13, 2024 and entitled "FOLDABLE ELECTRONIC DEVICE AND BENDING STRUCTURE", which is incorporated herein by reference in its entirety.

### TECHNICAL FIELD

This application relates to the field of terminal technologies, and in particular, to a foldable electronic device and a bending structure.

### BACKGROUND

With continuous development of electronic technologies, electronic devices such as computers and mobile phones have become indispensable communication tools in people's life. The electronic devices are available everywhere in life, greatly improving a living standard of people. With continuous improvement of user requirements, increasingly higher requirements are imposed on performance of electronic devices accordingly. In addition, higher requirements are also imposed on lightness, thinness, and miniaturization of foldable electronic devices. How to keep a bending form of a flexible circuit board basically unchanged to implement an electrical connection between the printed circuit board and a battery becomes a crucial focus.

An overall thickness of a foldable electronic device tends to decrease. To ensure that a battery specification of the entire device is not reduced, through-hinge space of the flexible circuit board is greatly reduced. In a conventional foldable electronic device, a fastening manner of a flexible circuit board may cause a through-hinge bending angle of the flexible circuit board to decrease. This affects a through-hinge form and a bending life of the flexible circuit board, and further affects water resistance of a through-hinge area of the foldable electronic device and signal integrity under bending.

### SUMMARY

This application provides a foldable electronic device and a bending structure. A thickness of the first middle frame is reduced to a specific extent by changing a fitting relationship between a first middle frame and a first press-fitting support, so that the first middle frame has a step structure. This facilitates lap joint between a first connection part of the first press-fitting support and the first middle frame, reduces a thickness size of the foldable electronic device in a second direction, and further implements a trend of reducing an overall thickness of the foldable electronic device.

A first aspect of this application provides a foldable electronic device, including:
a flexible circuit board, having a first end and a second end;
a hinge mechanism, where the flexible circuit board penetrates the hinge mechanism in a first direction;
a first middle frame, where the first middle frame has a first side and a second side in a second direction, a first opening is provided on the first middle frame, and the first opening allows the first end of the flexible circuit board to pass through and extends through the first side and the second side;
a second middle frame, where the first middle frame and the second middle frame are respectively located on two sides of the hinge mechanism and are rotatably connected to the hinge mechanism;
a first display, where the first display is located on one side of the first middle frame, the second middle frame, and the hinge mechanism, and is connected to the first middle frame, the second middle frame, and the hinge mechanism, and the first side of the first middle frame faces the first display; and
a first press-fitting support, where the first press-fitting support is located at the first opening, one end of the first press-fitting support has a first connection part, the first connection part is located on the first side of the first middle frame and is connected to the first side of the first middle frame, and another end of the first press-fitting support fits the first middle frame and is press-fitted on the flexible circuit board.

The foldable electronic device provided in this application includes the flexible circuit board, the hinge mechanism, the first middle frame, and the second middle frame. The flexible circuit board may penetrate the hinge mechanism in the first direction, so that a part of the flexible circuit board is located inside the hinge mechanism. The first middle frame and the second middle frame are respectively located on two sides of the hinge mechanism in the first direction, and the first middle frame and the second middle frame are respectively rotatably connected to the hinge mechanism. In this application, a thickness of the first middle frame is reduced to a specific extent by changing a fitting relationship between the first middle frame and the first press-fitting support, so that the first middle frame has a step structure. This facilitates lap joint between the first connection part of the first press-fitting support and the first middle frame, reduces a thickness size of the foldable electronic device in the second direction, and further implements a trend of reducing an overall thickness of the foldable electronic device.

In a possible implementation, a groove is provided at a position that is on the first side of the first middle frame and that faces the first connection part, and at least a part of the first connection part is located in the groove and is in lap joint with a groove bottom of the groove.

The connection between the first connection part and the first side of the first middle frame is implemented by fitting the first connection part with the groove. A partial thickness of the first middle frame is reduced in the second direction, and the first connection part is in lap joint with the groove bottom of the groove, so that the first side of the first middle frame and the first connection part are staggered, thereby reducing an overall thickness.

In a possible implementation, the first middle frame has a first lap joint part close to the first opening, the first lap joint part extends in a third direction, the groove is provided on a surface that is of the first lap joint part and that faces the first display, the first connection part of the first press-fitting support is located on a side that is of the first lap joint part and that faces the first display, and the first connection part and the first lap joint part overlap and are connected in the second direction.

The first lap joint part is disposed, and the groove is provided on the surface that is of the first lap joint part and that faces the first display, so that the first lap joint part and the groove form a step structure, thereby facilitating lap joint between the first connection part of the first press-fitting support and the first lap joint part.

In a possible implementation, the first press-fitting support further has a second connection part.

The first middle frame has a second lap joint part at the first opening, a first channel that allows the first end of the flexible circuit board to penetrate is provided between the second connection part and the second lap joint part, and the flexible circuit board penetrates the first channel and is sealedly connected to the second connection part and the second lap joint part.

The second connection part, the first channel, and the second lap joint part are disposed, so that one surface of the flexible circuit board is sealedly connected to the second connection part, and the other surface of the flexible circuit board is sealedly connected to the second lap joint part, thereby further achieving good water resistance performance.

In a possible implementation, a first arc-shaped concave part is provided on a surface that is of the second lap joint part and that faces the second connection part, and the second connection part has a first arc-shaped convex surface that protrudes toward the first arc-shaped concave part.

The first channel that is in an arc shape is formed between the first arc-shaped convex surface and the first arc-shaped concave part.

The first arc-shaped convex surface and the first arc-shaped concave part are disposed, so that the first channel in the arc shape is formed between the first arc-shaped convex surface and the first arc-shaped concave part. The first end of the flexible circuit board penetrates the first channel in the arc shape, to facilitate bending of the flexible circuit board and enhance bending reliability of the flexible circuit board.

In a possible implementation, first redundant space that allows the flexible circuit board to bend is provided between the second connection part and the second lap joint part, the first redundant space communicates with the first channel, the first redundant space is close to the hinge mechanism, and the flexible circuit board is bent in a W shape and disposed in the first redundant space and the first channel.

By disposing the first redundant space, a problem of distortion and abnormal sound when the flexible circuit board is bent can be avoided, to ensure that the flexible circuit board can be bent in space limited by the first middle frame and the first press-fitting support.

In a possible implementation, a first sealing adhesive layer is further included, where the first lap joint part is sealedly connected to the first connection part of the first press-fitting support through the first sealing adhesive layer.

The first sealing adhesive layer is disposed between the first lap joint part and the first connection part of the first press-fitting support, which has a specific water resistance function.

In a possible implementation, in the second direction, a surface that is of the first sealing adhesive layer and that faces the second side of the first middle frame is lower than a surface that is of the first lap joint part and that is located on the second side of the first middle frame.

The surface that is of the first sealing adhesive layer and that faces the second side of the first middle frame is disposed to be lower than the surface that is of the first lap joint part and that is located on the second side of the first middle frame, so that the first sealing adhesive layer is thin in the second direction, and does not protrude from the surface that is of the first lap joint part and that is located on the second side of the first middle frame, to avoid impact of the first sealing adhesive layer on another component located on the second side of the first middle frame.

In a possible implementation, a second display is further included, where the second display is located on the second side of the first middle frame, and the second display is connected to the first middle frame.

By disposing the second display, and with reference to a position of the first sealing adhesive layer between the first lap joint part and the first connection part, a problem that the second display has a shadow if the first sealing adhesive layer is excessively thick is avoided.

In a possible implementation, a first sealing piece and a second sealing piece are further included, where the first sealing piece and the second sealing piece are located in the first channel and are far away from the hinge mechanism.

The first sealing piece is located between the first arc-shaped convex surface and the flexible circuit board, to sealedly connect the first arc-shaped convex surface and the flexible circuit board.

The second sealing piece is located between the first arc-shaped concave part and the flexible circuit board, to sealedly connect the first arc-shaped concave part and the flexible circuit board.

The first sealing piece and the second sealing piece are disposed in the first channel and cooperate with the flexible circuit board, so that water resistance performance of the entire device is further enhanced, and liquid does not enter the first channel to corrode a circuit.

In a possible implementation, a second press-fitting support is further included.

A second opening that allows the second end of the flexible circuit board to pass through is provided on the second middle frame.

The second press-fitting support is located at the second opening, and the second press-fitting support is sealedly connected to an edge of the second middle frame at the second opening.

The second press-fitting support is disposed, so that the second end of the flexible circuit board can be limited. The second press-fitting support is sealedly connected to the edge of the second middle frame at the second opening, so that the entire device further has a good water resistance function.

In a possible implementation, one end of the second press-fitting support has a third connection part, and the second middle frame has a third lap joint part at the second opening.

The third connection part is located on a side that is of the third lap joint part and that faces the first display, and is sealedly connected to the third lap joint part.

Alternatively, the third connection part is located on a side that is of the third lap joint part and that faces away from the first display, and is sealedly connected to the third lap joint part.

The third connection part and the third lap joint part are disposed, and a groove is disposed on a surface that is of the third lap joint part and that faces the first display, so that the third lap joint part and the groove form a step structure, thereby facilitating lap joint between the third connection part of the second press-fitting support and the third lap joint part.

In a possible implementation, a second sealing adhesive layer is further included, where the second sealing adhesive layer is located between the third connection part and the third lap joint part.

The second sealing adhesive layer is disposed between the third connection part and the third lap joint part, which has a specific water resistance function.

In a possible implementation, the second middle frame has a fourth lap joint part at the second opening, and the second press-fitting support has a fourth connection part.

A second channel that allows the second end of the flexible circuit board to penetrate is provided between the fourth connection part and the fourth lap joint part, and the flexible circuit board penetrates the second channel and is sealedly connected to the fourth connection part and the fourth lap joint part.

The fourth connection part, the second channel, and the fourth lap joint part are disposed, so that one surface of the flexible circuit board is sealedly connected to the fourth connection part, and the other surface of the flexible circuit board is sealedly connected to the fourth lap joint part, thereby further achieving good water resistance performance.

In a possible implementation, a second arc-shaped concave part is provided on a surface that is of the fourth lap joint part and that faces the fourth connection part, and the fourth connection part has a second arc-shaped convex surface that protrudes toward the second arc-shaped concave part.

The second channel that is in an arc shape is formed between the second arc-shaped convex surface and the second arc-shaped concave part.

The second arc-shaped convex surface and the second arc-shaped concave part are disposed, so that the second channel in the arc shape is formed between the second arc-shaped convex surface and the second arc-shaped concave part. The second end of the flexible circuit board penetrates the second channel in the arc shape, to facilitate bending of the flexible circuit board and enhance bending reliability of the flexible circuit board.

In a possible implementation, a third sealing piece and a fourth sealing piece are further included, where the third sealing piece and the fourth sealing piece are located in the second channel and are far away from the hinge mechanism.

The third sealing piece is located between the second arc-shaped convex surface and the flexible circuit board, to sealedly connect the second arc-shaped convex surface and the flexible circuit board.

The fourth sealing piece is located between the second arc-shaped concave part and the flexible circuit board, to sealedly connect the second arc-shaped concave part and the flexible circuit board.

The third sealing piece and the fourth sealing piece are disposed in the second channel and cooperate with the flexible circuit board, so that water resistance performance of the entire device is further enhanced, and liquid does not enter the second channel to corrode a circuit.

In a possible implementation, second redundant space that allows the flexible circuit board to bend is provided between the fourth connection part and the fourth lap joint part, the second redundant space communicates with the second channel, the second redundant space is close to the hinge mechanism, and the flexible circuit board is bent in a W shape and disposed in the second redundant space and the second channel.

By disposing the second redundant space, a problem of distortion and abnormal sound when the flexible circuit board is bent can be avoided, to ensure that the flexible circuit board can be bent in space limited by the second middle frame and the second press-fitting support.

In a possible implementation, a battery cover is further included.

The battery cover is located on a side that is of the second middle frame and that faces away from the first display, and the battery cover is connected to the second middle frame.

The battery cover is disposed, so that the battery cover and the second display are respectively located at two ends of the hinge mechanism in the first direction. In this way, the entire device has a good appearance.

In a possible implementation, a first reinforcement part is further included.

The first reinforcement part is located on at least one side of the first end of the flexible circuit board, the first reinforcement part is located between the flexible circuit board and the first press-fitting support, and two sides of the first reinforcement part are respectively sealedly connected to the flexible circuit board and the first press-fitting support.

Alternatively, the first reinforcement part is located between the flexible circuit board and the first middle frame, and two sides of the first reinforcement part are respectively sealedly connected to the flexible circuit board and the first middle frame.

The first reinforcement part is disposed to increase strength and rigidity of the first end of the flexible circuit board, so as to prevent the first end of the flexible circuit board from being deformed or damaged in a use process.

In a possible implementation, a second reinforcement part is further included.

The second reinforcement part is located on at least one side of the second end of the flexible circuit board, the second reinforcement part is located between the flexible circuit board and the second press-fitting support, and two sides of the second reinforcement part are respectively sealedly connected to the flexible circuit board and the second press-fitting support.

Alternatively, the second reinforcement part is located between the flexible circuit board and the second middle frame, and two sides of the second reinforcement part are respectively sealedly connected to the flexible circuit board and the second middle frame.

The second reinforcement part is disposed to increase strength and rigidity of the second end of the flexible circuit board, so as to prevent the second end of the flexible circuit board from being deformed or damaged in a use process.

In a possible implementation, a flexible part is provided on a surface that is of the first display and that faces the hinge mechanism, and the flexible part is stacked on the first display.

A front projection of the hinge mechanism toward the first display covers the flexible part.

The flexible part is disposed on the surface that is of the first display and that faces the hinge mechanism, thereby improving bending reliability of the entire foldable electronic device.

A second aspect of this application provides a bending structure, including:
a hinge mechanism;
a first middle frame, where the first middle frame is located on one side of the hinge mechanism and is rotatably connected to the hinge mechanism; and
a first press-fitting support, where a first opening is provided on the first middle frame, the first press-fitting support is located at the first opening, and an edge that is of the first middle frame and at which the first opening is provided is in lap joint with one end of the first press-fitting support.

The bending structure is configured to support a flexible circuit board and a first display.

The bending structure provided in this application includes the hinge mechanism, the first middle frame, and the first press-fitting support. The first middle frame is located on the side of the hinge mechanism and is rotatably connected to the hinge mechanism. The first opening is provided on the first middle frame, the first press-fitting support is located at the first opening, and the edge that is of the first middle frame and at which the first opening is provided is in lap joint with the end of the first press-fitting support. The bending structure provided in this application can support a flexible circuit board and a first display of a foldable electronic device.

It should be understood that the technical solutions in the second aspect of this application correspond to the technical solutions in the first aspect of this application, and beneficial effect achieved by the aspects and corresponding feasible implementations are similar. Details are not described again.

### BRIEF DESCRIPTION OF DRAWINGS

FIG. 1 is a diagram of an overall structure of a foldable electronic device according to an embodiment of this application;
FIG. 2 is a diagram of an overall structure of a foldable electronic device from another perspective according to an embodiment of this application;
FIG. 3 is a diagram of a structure of a foldable electronic device;
FIG. 4 is a diagram of a structure of a first middle frame and a flexible circuit board of a foldable electronic device according to an embodiment of this application;
FIG. 5 is an exploded diagram of a first middle frame and a flexible circuit board of a foldable electronic device according to an embodiment of this application;
FIG. 6 is a diagram of a partial structure of a foldable electronic device according to an embodiment of this application;
FIG. 7 is a diagram of a partial cross section at A-A in FIG. 4;
FIG. 8 is a diagram of a structure of a foldable electronic device in a folded state according to an embodiment of this application; and
FIG. 9 is a diagram of a partial structure of another foldable electronic device according to an embodiment of this application.

Descriptions of reference numerals:
100: foldable electronic device;
110: flexible circuit board; 111: first end; 112: second end;
113: first reinforcement part; 114: second reinforcement part;
120: hinge mechanism; 121: rotating shaft body; 122: rotating shaft back cover;
123: first redundant space; 124: second redundant space;
130: first middle frame; 131: first side; 132: second side;
133: first opening; 134: first lap joint part; 1341: groove;
135: first sealing adhesive layer; 136: second lap joint part; 1361: first arc-shaped concave part;
137: first channel; 138: first sealing piece; 139: second sealing piece;
140: second middle frame; 141: second opening; 142: third lap joint part;
143: second sealing adhesive layer; 144: fourth lap joint part; 1441: second arc-shaped concave part;
145: second channel; 146: third sealing piece; 147: fourth sealing piece;
150: first display; 151: flexible part;
160: first press-fitting support; 161: first connection part; 162: second connection part;
1621: first arc-shaped convex surface;
170: second display;
180: second press-fitting support; 181: third connection part; 182: fourth connection part;
1821: second arc-shaped convex surface; and
190: battery cover.

### DESCRIPTION OF EMBODIMENTS

Terms used in implementations of this application are merely intended to describe specific embodiments of this application, but not to limit this application. The following describes implementations of embodiments of this application in detail with reference to the accompanying drawings.

Unless otherwise required in the context, throughout this specification and claims, the term "include (comprise)" and other forms of the term, for example, a third person singular form "includes (comprises)" and a present participle form "including (comprising)", are interpreted as "open and inclusive", namely, "include but not limited to". In descriptions of this specification, terms such as "one embodiment (one embodiment)", "some embodiments (some embodiments)", "example embodiments (exemplary embodiments)", "example (example)", or "some examples (some examples)" are intended to indicate that a particular feature, structure, material, or characteristic related to this embodiment or example are included in at least one embodiment or example of this disclosure. The foregoing schematic representations of the terms do not necessarily refer to a same embodiment or example. Further, the particular feature, structure, material, or characteristic may be included in any one or more embodiments or examples in any appropriate manner.

In addition, in embodiments of this application, position terms such as "front" and "back" are defined relative to positions of components in the accompanying drawings. It should be understood that these position terms are relative concepts used for relative description and clarification, and may correspondingly change based on changes in the positions of the components in the accompanying drawings.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

A first aspect of embodiments of this application provides a foldable electronic device. It may be understood that the foldable electronic device may be a mobile terminal device like a mobile phone, a tablet computer, a notebook computer, a personal digital assistant (Personal Digital Assistant, PDA), an intelligent wearable device, or a point of sales (Point of Sales, POS), or the foldable electronic device may be a fixed terminal device like a smart television, a router, a server, or a switch. This is not limited in embodiments.

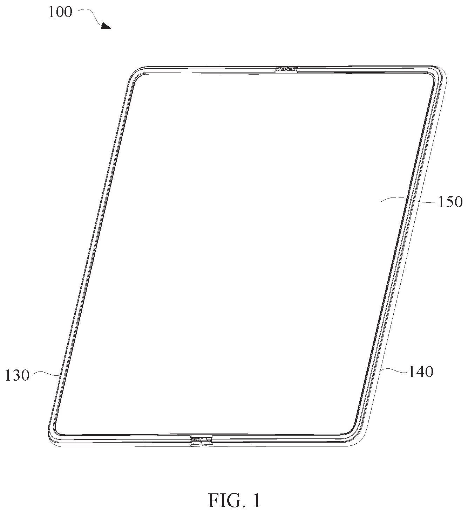

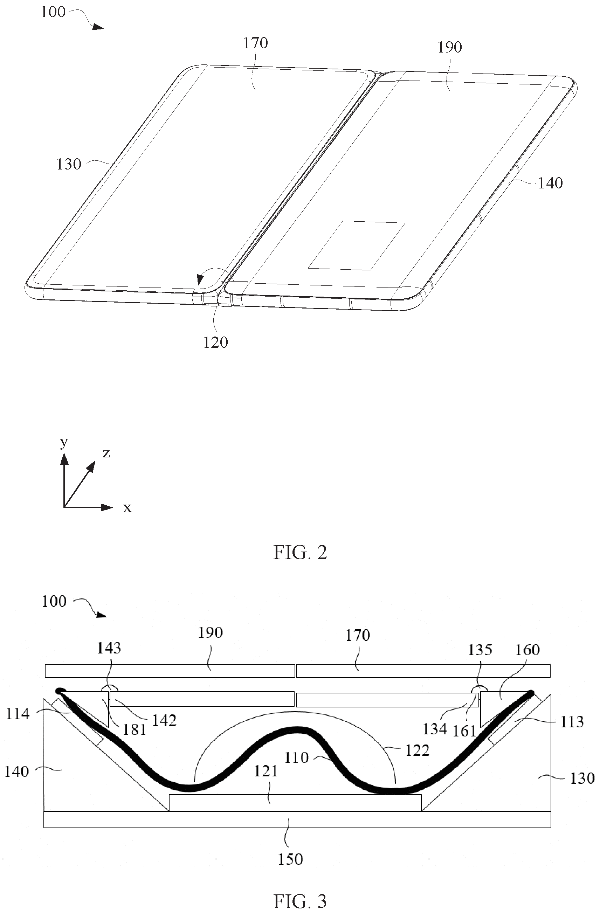

Refer to FIG. 1 and FIG. 2. A foldable electronic device 100 may include at least a first display 150, a battery cover 190, a battery, a hinge mechanism 120, and a flexible circuit board that penetrates the hinge mechanism 120. The battery may be electrically connected to the flexible circuit board. In a possible implementation, an example in which a mobile phone is the foldable electronic device 100 is used for description. FIG. 1 and FIG. 2 are respectively diagrams of an overall structure of the foldable electronic device 100 from two perspectives.

Based on the foregoing embodiments, refer to FIG. 1 and FIG. 2. The foldable electronic device 100 may further include a first middle frame 130 and a second middle frame 140. The first middle frame 130 and the second middle frame 140 may be respectively located at two ends of the hinge mechanism 120, and the hinge mechanism 120 is rotated to implement a folded state and an unfolded state of the first middle frame 130 and the second middle frame 140. One surface of the first middle frame 130 is connected to the first display 150, and another surface of the first middle frame 130 is connected to the second display 170. Correspondingly, one surface of the second middle frame 140 is connected to the first display 150, and another surface of the second middle frame 140 is connected to the battery cover 190. The battery may be disposed on a surface that is of the second middle frame 140 and that faces the battery cover 190. It may be understood that, internal space enclosed by connecting the battery cover 190 and the second middle frame 140 is hollow, and the battery may be mounted in the internal space.

For example, the battery cover 190 may be a metal rear cover, or may be a glass rear cover, or may be a plastic rear cover, or may be a ceramic rear cover. In embodiments of this application, a material of the battery cover 190 is not limited, and is not limited to the foregoing examples.

It may be understood that the structure shown in embodiments of this application does not constitute a specific limitation on the foldable electronic device. In some other embodiments of this application, the foldable electronic device 100 (for example, the mobile phone) may include more or fewer components than those shown in the figure, or some components may be combined, or some components may be split, or different component arrangements may be used. The components shown in the figure may be implemented by hardware, software, or a combination of software and hardware.

To achieve a development objective that an overall thickness of the foldable electronic device 100 tends to decrease, in the foldable electronic device 100 (for example, the mobile phone), space of an axis area needs to be further compressed to ensure a battery capacity of the entire device.

FIG. 3 is a diagram of a structure of the foldable electronic device 100. Refer to FIG. 3. The foldable electronic device 100 may include the first display 150, the second display 170, the first middle frame 130, the second middle frame 140, the hinge mechanism 120, and a flexible circuit board 110 that penetrates the hinge mechanism 120. The first display 150 is located on one side of the first middle frame 130, the second middle frame 140, and the hinge mechanism 120, the second display 170 is located on one side that is of the first middle frame 130 and that faces away from the first display 150, the first middle frame 130 and the second middle frame 140 are respectively located on two sides of the hinge mechanism 120 in a first direction, and the first middle frame 130 and the second middle frame 140 are respectively rotatably connected to the hinge mechanism 120. The flexible circuit board 110 penetrates the hinge mechanism 120, one end of the flexible circuit board 110 penetrates the first middle frame 130 and extends out of the first middle frame 130, and the other end of the flexible circuit board 110 penetrates the second middle frame 140 and extends out of the second middle frame 140.

However, the foldable electronic device 100 shown in FIG. 3 has the following disadvantages. In the foldable electronic device 100, the first middle frame 130 may not be very thin due to a limitation of a manufacturing process. In a future trend of miniaturization of the foldable electronic device 100, it is not conducive to lightness, thinness, and holding experience for the foldable electronic device 100. Especially, a foldable phone is used as an example. More users use foldable phones as main mobile phones. However, a thickness of the foldable phone is close to twice a thickness of a conventional mobile phone, resulting in poor holding experience of a user.

In addition, the foldable phone is still used as an example. If the flexible circuit board 110 is not sealed with an adhesive layer in a through-hinge area, there may be a specific gap between the first middle frame 130 and the flexible circuit board 110, and a water resistance function of the entire device cannot be implemented. If a sealing adhesive layer between the flexible circuit board 110 and the first middle frame 130 is excessively thick, a light and shadow problem of the second display 170 of the entire device may be caused, affecting use performance of the foldable electronic device 100.

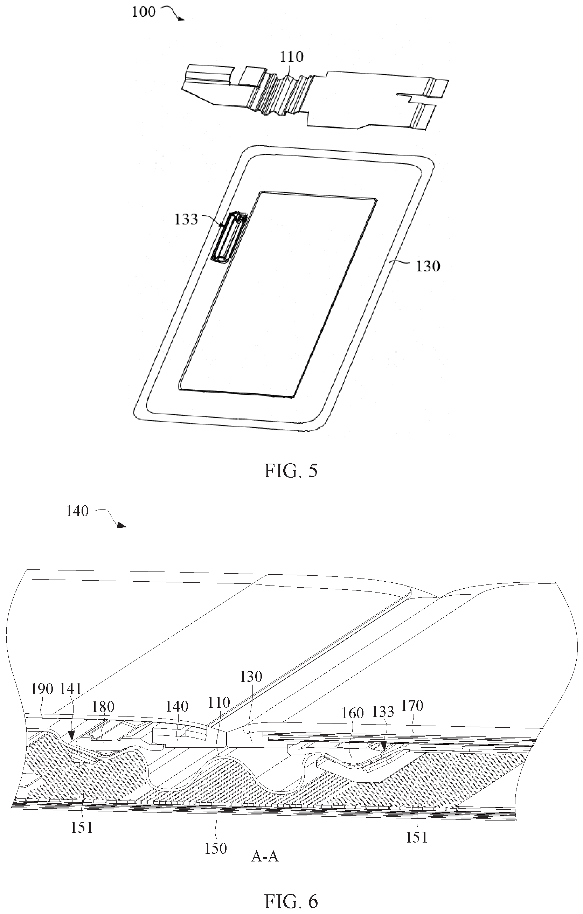

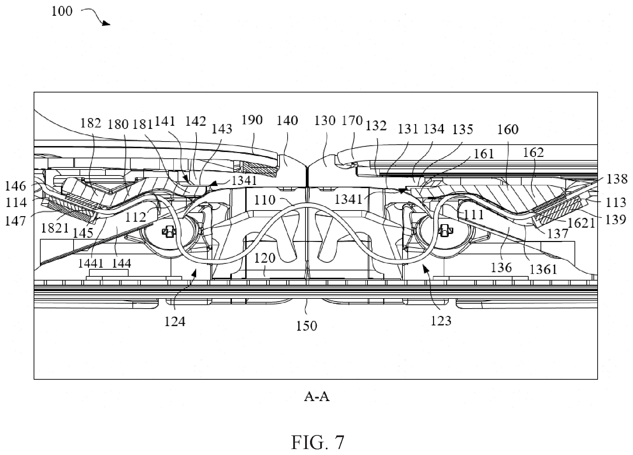

In view of this, Embodiments of this application provide the foldable electronic device 100. As shown in FIG. 6 and FIG. 7, in the foldable electronic device 100, a thickness of the first middle frame 130 is reduced to a specific extent by changing a fitting relationship between the first middle frame 130 and the first press-fitting support 160, and a groove 1341 is provided on a surface that is of a first lap joint part 134 of the first middle frame 130 and that faces the first display 150, so that the first lap joint part 134 and the groove 1341 form a step structure. This facilitates lap joint between a first connection part 161 of the first press-fitting support 160 and the first lap joint part 134. A first sealing adhesive layer 135 is disposed between the first connection part 161 and the first lap joint part 134, and has good water resistance performance.

The following uses specific embodiments as an example to describe a specific structure of the foldable electronic device 100 with reference to the accompanying drawings.

Refer to FIG. 1, FIG. 2, and FIG. 6. Embodiments of this application provide the foldable electronic device 100. The foldable electronic device 100 may include the flexible circuit board 110, the hinge mechanism 120, the first middle frame 130, and the second middle frame 140. The flexible circuit board 110 may penetrate the hinge mechanism 120 in the first direction, so that a part of the flexible circuit board 110 is located inside the hinge mechanism 120. The first middle frame 130 and the second middle frame 140 are respectively located on two sides of the hinge mechanism 120 in the first direction, and the first middle frame 130 and the second middle frame 140 are respectively rotatably connected to the hinge mechanism 120.

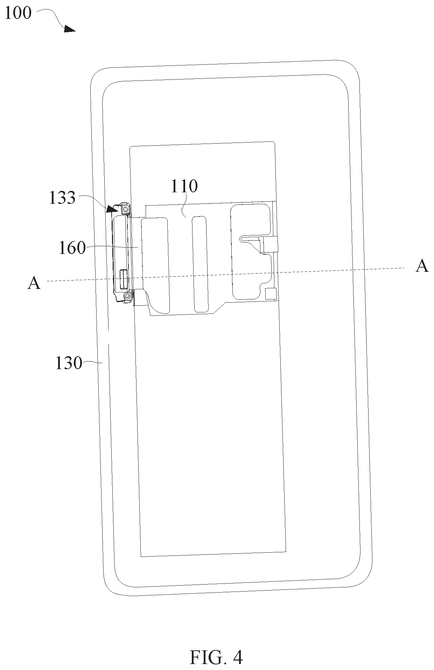

Refer to FIG. 7. In a possible implementation, the flexible circuit board 110 may have a first end 111 and a second end 112, and the first middle frame 130 may have a first side 131 and a second side 132 in a second direction. As shown in FIG. 4 and FIG. 5, a first opening 133 may be provided on the first middle frame 130. In embodiments of this application, the first opening 133 allows the first end 111 of the flexible circuit board 110 to pass through, and the first opening 133 extends through the first side 131 and the second side 132 of the first middle frame 130.

For ease of description, in embodiments of this application, the first direction is a width direction of the foldable electronic device 100, namely, an x direction in FIG. 2. The second direction is a thickness direction of the foldable electronic device 100, namely, a y direction in FIG. 2. A third direction is a length direction of the foldable electronic device 100, namely, a z direction in FIG. 2. The first direction, the second direction, and the third direction are perpendicular to each other.

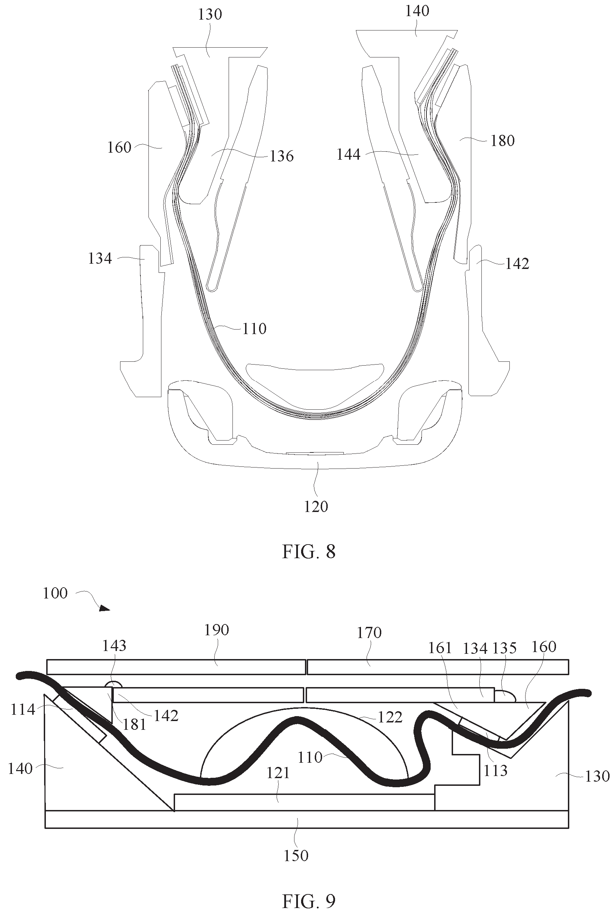

Still refer to FIG. 7. Based on the foregoing embodiments, the foldable electronic device 100 may further include the first display 150. The first display 150 may be located on one side of the first middle frame 130, the second middle frame 140, and the hinge mechanism, and the first display 150 can be connected to the first middle frame 130, the second middle frame 140, and the hinge mechanism 120. The first side 131 of the first middle frame 130 faces the first display 150. It may be understood that, as shown in FIG. 8, when the hinge mechanism 120 is rotated to enable the foldable electronic device 100 to be in a folded state, the first middle frame 130 and the second middle frame 140 are disposed opposite to each other, and at least a part of the hinge mechanism 120 is exposed between the first middle frame 130 and the second middle frame 140. When the hinge mechanism 120 is rotated to enable the foldable electronic device 100 to be in an unfolded state, the first middle frame 130 and the second middle frame 140 are located on a same horizontal plane, there is an accommodation cavity between the first middle frame 130, the second middle frame 140, and the first display 150, and a rotating shaft assembly is located in the accommodation cavity.

Still refer to FIG. 6. Based on the foregoing embodiments, the foldable electronic device 100 may further include the first press-fitting support 160. As shown in FIG. 4, the first press-fitting support 160 is located at the first opening 133. In a possible implementation, as shown in FIG. 6 and FIG. 7, one end of the first press-fitting support 160 has a first connection part 161, the first connection part 161 is located on the first side 131 of the first middle frame 130, and the first connection part 161 is connected to the first side 131 of the first middle frame 130. Correspondingly, another end of the first press-fitting support 160 may fit the first middle frame 130, and the another end of the first press-fitting support 160 can be press-fitted on the flexible circuit board 110, to limit a part of the flexible circuit board 110. In this way, the first connection part 161 is disposed to be connected to the first side 131 of the first middle frame 130, so that the first connection part 161 and the first side 131 of the first middle frame 130 are staggered. This reduces a thickness of the foldable electronic device 100 in the second direction, and further implements a trend of reducing the overall thickness of the foldable electronic device 100.

Still refer to FIG. 7. Based on the foregoing embodiments, the groove 1341 may be provided at a position that is on the first side 131 of the first middle frame 130 and that faces the first connection part 161. At least a part of the first connection part 161 may be located in the groove 1341 and may be in lap joint with a groove bottom of the groove 1341, so that the first connection part 161 is connected to the first side 131 of the first middle frame 130 by fitting the first connection part 161 with the groove 1341. In this way, at least a portion of a projection of the first side 131 of the first middle frame 130 toward the first connection part 161 coincides with the first connection part 161, and a partial thickness of the first middle frame 130 is reduced in the second direction by providing the groove 1341 on the first side 131 of the first middle frame 130, and the first connection part 161 is in lap joint with the groove bottom of the groove 1341, so that the first side 131 of the first middle frame 130 and the first connection part 161 are staggered, thereby reducing an overall thickness.

Still refer to FIG. 7. Based on the foregoing embodiments, the first middle frame 130 may have the first lap joint part 134 close to the first opening 133, and the first lap joint part 134 extends in the third direction. It may be understood that the groove 1341 may be provided on a surface that is of the first lap joint part 134 and that faces the first display 150, and the first connection part 161 of the first press-fitting support 160 is located on a side that is of the first lap joint part 134 and that faces the first display 150. In this way, the first connection part 161 and the first lap joint part 134 can overlap and be connected in the second direction. The first lap joint part 134 fits the groove 1341 to form a step structure. This facilitates lap joint between the first connection part 161 and the first lap joint part 134.

Still refer to FIG. 7. Based on the foregoing embodiments, the foldable electronic device 100 may further include the first sealing adhesive layer 135. The first lap joint part 134 may be sealedly connected to the first connection part 161 of the first press-fitting support 160 through the first sealing adhesive layer 135. In embodiments of this application, glue dispensing may be directly performed on the first lap joint part 134 and the first connection part 161, or the first lap joint part 134 and the first connection part 161 may be connected through another adhesive, to implement a connection between the first middle frame 130 and the first press-fitting support 160. It may be understood that the first sealing adhesive layer 135 has a specific water resistance function.

Still refer to FIG. 7. Based on the foregoing embodiment, in the second direction, a surface that is of the first sealing adhesive layer 135 and that faces the second side 132 of the first middle frame 130 is lower than a surface that is of the first lap joint part 134 and that is located on the second side 132 of the first middle frame 130. In this way, the surface that is of the first sealing adhesive layer 135 and that faces the second side 132 of the first middle frame 130 is disposed to be lower than the surface that is of the first lap joint part 134 and that is located on the second side 132 of the first middle frame 130, so that the first sealing adhesive layer 135 is thin in the second direction, and does not protrude from the surface that is of the first lap joint part 134 and that is located on the second side 132 of the first middle frame 130, to avoid impact of the first sealing adhesive layer 135 on another component located on the second side 132 of the first middle frame 130.

Still refer to FIG. 7. Based on the foregoing embodiments, the foldable electronic device 100 may further include the second display 170. The second display 170 may be located on the second side 132 of the first middle frame 130, and the second display 170 is connected to the first middle frame 130. In embodiments of this application, it may be understood that, if the first sealing adhesive layer 135 is excessively thick, that is, the surface that is of the first sealing adhesive layer 135 and that faces the second side 132 of the first middle frame 130 is higher than the surface that is of the first lap joint part 134 and that is located on the second side 132 of the first middle frame 130, the first sealing adhesive layer 135 exerts a specific external force toward the second display 170 in the second direction. When human eyes observe the second display 170 at a specific angle, wave-like patterns may appear on the second display 170, causing a light and shadow problem of the second display 170 of the foldable electronic device 100.

It may be understood that, to further reduce the thickness of the foldable electronic device 100 in the second direction, a thickness of the first middle frame 130 in the second direction is also reduced. When the thickness of the first middle frame 130 is reduced to be the same as a height of the first press-fitting support 160, the first sealing adhesive layer 135 may protrude from the surface that is of the first lap joint part 134 and that is located on the second side 132 of the first middle frame 130, which is likely to cause a light and shadow problem of the second display 170. If the thickness of the first middle frame 130 is further reduced to reduce the overall thickness, manufacturability and processability of the first middle frame 130 cannot be met, and a manufacturing process is difficult to implement. Therefore, when the requirement is met, after the thickness of the first middle frame 130 is reduced to a specific extent, the groove 1341 is provided on the surface that is of the first lap joint part 134 of the first middle frame 130 and that faces the first display 150, so that the first lap joint part 134 and the groove 1341 form a step structure. This facilitates lap joint between the first connection part 161 and the first lap joint part 134. In this way, reducing the thickness of the first middle frame 130 implements a trend of reducing the overall thickness of the foldable electronic device 100 and further ensures strength and processability of the first middle frame 130. In addition, the position of the first sealing adhesive layer 135 can meet a water resistance requirement of the foldable electronic device 100.

Still refer to FIG. 7. Based on the foregoing embodiments, the first press-fitting support 160 may further have a second connection part 162. Correspondingly, the first middle frame 130 may have a second lap joint part 136 at the first opening 133. In a possible implementation, there is a first channel 137 between the second connection part 162 and the second lap joint part 136. The first channel 137 allows the first end 111 of the flexible circuit board 110 to penetrate. In this way, the flexible circuit board 110 may penetrate the first channel 137 and may be sealedly connected to the second connection part 162 and the second lap joint part 136. It may be understood that at least a part of the flexible circuit board 110 is located between the second lap joint part 136 and the second connection part 162, one surface of the flexible circuit board 110 is sealedly connected to the second connection part 162, and the other surface of the flexible circuit board 110 is sealedly connected to the second lap joint part 136, thereby further achieving good water resistance performance.

Still refer to FIG. 7. Based on the foregoing embodiments, in a possible implementation, a first arc-shaped concave part 1361 may be provided on a surface that is of the second lap joint part 136 and that faces the second connection part 162, and correspondingly, as shown in FIG. 7, the second connection part 162 has a first arc-shaped convex surface 1621 that protrudes toward the first arc-shaped concave part 1361. In this way, the first arc-shaped concave part 1361 can fit the first arc-shaped convex surface 1621, so that the first channel 137 in an arc shape is formed between the first arc-shaped convex surface 1621 and the first arc-shaped concave part 1361. The first end 111 of the flexible circuit board 110 penetrates the first channel 137 in the arc shape, to facilitate bending of the flexible circuit board 110 and enhance bending reliability of the flexible circuit board 110.

Still refer to FIG. 7. Based on the foregoing embodiments, the foldable electronic device 100 may further include a first sealing piece 138 and a second sealing piece 139. The first sealing piece 138 and the second sealing piece 139 are located in the first channel 137 and are far away from the hinge mechanism 120. In embodiments of this application, the first sealing piece 138 may be located between the first arc-shaped convex surface 1621 and the flexible circuit board 110, to sealedly connect the first arc-shaped convex surface 1621 and the flexible circuit board 110, so as to sealedly connect the second connection part 162 and the flexible circuit board 110. Correspondingly, the second sealing piece 139 may be located between the first arc-shaped concave part 1361 and the flexible circuit board 110, to sealedly connect the first arc-shaped concave part 1361 and the flexible circuit board 110, so as to sealedly connect the second lap joint part 136 and the flexible circuit board 110. In this way, disposing the first sealing piece 138 and the second sealing piece 139 further enhances water resistance performance of the entire device.

It may be understood that, in a rotation process of the hinge mechanism 120, liquid may enter the entire device from the hinge mechanism 120. In embodiments of this application, a surface that is of the first connection part 161 of the first press-fitting support 160 and that faces the second display 170 is sealedly connected to the first lap joint part 134 through the first sealing adhesive layer 135, a surface that is of the second connection part 162 of the first press-fitting support 160 and that faces the first display 150 is sealedly connected to the flexible circuit board 110 through the first sealing piece 138, and the second lap joint part 136 is sealedly connected to the flexible circuit board 110 through the second sealing piece 139. In this way, at a specific depth and specific pressure, no liquid enters the entire device from the hinge mechanism 120, thereby preventing the liquid from entering the first channel 137 and corroding a circuit.

Still refer to FIG. 7. Based on the foregoing embodiments, first redundant space 123 that allows the flexible circuit board 110 to bend may further be provided between the second connection part 162 and the second lap joint part 136. The first redundant space 123 communicates with the first channel 137, and the first redundant space 123 is disposed close to the hinge mechanism 120. It may be understood that the first end 111 of the flexible circuit board 110 penetrates the hinge mechanism 120, and then extends out of the first channel 137 along the first redundant space 123 through the first channel 137. In a penetration process of the flexible circuit board 110, disposing the first redundant space 123 can avoid a problem of distortion and abnormal sound when the flexible circuit board 110 is bent.

It may be understood that the first middle frame 130 is provided with the second lap joint part 136 at the first opening 133, so that the flexible circuit board 110 bypasses the second lap joint part 136 and penetrates the first channel 137, and the flexible circuit board 110 is disposed in a bent shape. In addition, disposing the first redundant space 123 enables the flexible circuit board 110 to be bent to a greater extent. In this way, with reference to FIG. 7, the flexible circuit board 110 may be disposed in the first redundant space 123 and the first channel 137 in a bendable manner in a W shape.

Still refer to FIG. 7. Based on the foregoing embodiments, the foldable electronic device 100 may further include a second press-fitting support 180. A second opening 141 may be provided on the second middle frame 140. In embodiments of this application, the second opening 141 allows the second end 112 of the flexible circuit board 110 to pass through, and the second press-fitting support 180 is located at the second opening 141. It may be understood that the second press-fitting support 180 is sealedly connected to an edge of the second middle frame 140 at the second opening 141, to obtain a good water resistance function.

In a possible implementation, one end of the second press-fitting support 180 may have a third connection part 181. The third connection part 181 is sealedly connected to the edge of the second middle frame 140 at the second opening 141. Correspondingly, another end of the second press-fitting support 180 may fit the second middle frame 140, and the another end of the second press-fitting support 180 can be press-fitted on the flexible circuit board 110, to limit a part of the flexible circuit board 110. In this way, the first press-fitting support 160 is press-fitted on the first end 111 of the flexible circuit board 110, the second press-fitting support 180 is press-fitted on the second end 112 of the flexible circuit board 110, and a middle area of the flexible circuit board 110 is located in the hinge mechanism 120, so that the entire flexible circuit board 110 is placed in an internal structure of the entire device. In addition, the third connection part 181 is disposed to connect to the edge of the second middle frame 140 at the second opening 141, so that a thickness size of the foldable electronic device 100 in the second direction can be further reduced, thereby implementing a trend of reducing the overall thickness of the foldable electronic device 100.

Still refer to FIG. 7. Based on the foregoing embodiments, a groove 1341 may also be provided at a position that is of the second middle frame 140 and that faces the third connection part 181. The groove 1341 provided on the second middle frame 140 may be the same as the groove 1341 provided on the first middle frame 130. At least a part of the third connection part 181 may be located in the groove 1341 and may be in lap joint with a groove bottom of the groove 1341, so that the third connection part 181 is connected to the edge of the second middle frame 140 at the second opening 141 by fitting the third connection part 181 with the groove 1341. In this way, at least a part of a projection of the edge of the second middle frame 140 at the second opening 141 toward the third connection part 181 coincides with the third connection part 181, and a partial thickness of the second middle frame 140 is reduced in the second direction by providing the groove 1341 on the edge of the second middle frame 140 at the second opening 141, and the third connection part 181 is in lap joint with the groove bottom of the groove 1341, so that the edge of the second middle frame 140 at the second opening 141 and the third connection part 181 are staggered, thereby reducing an overall thickness.

Still refer to FIG. 7. Based on the foregoing embodiments, the second middle frame 140 has a third lap joint part 142 at the second opening 141. It may be understood that the groove 1341 may be provided on a surface that is of the third lap joint part 142 and that faces the first display 150, the third connection part 181 of the second press-fitting support 180 is located on a side that is of the third lap joint part 142 and that faces the first display 150, and the third connection part 181 is sealedly connected to the third lap joint part 142. In this way, the third connection part 181 and the third lap joint part 142 can overlap and be connected in the second direction. The third lap joint part 142 fits the groove 1341 to form a step structure. This facilitates lap joint between the third connection part 181 and the third lap joint part 142.

Still refer to FIG. 7. Based on the foregoing embodiments, the foldable electronic device 100 may further include a second sealing adhesive layer 143. The second sealing adhesive layer 143 may be located between the third connection part 181 and the third lap joint part 142, so that the third lap joint part 142 is sealedly connected to the third connection part 181 through the second sealing adhesive layer 143. In embodiments of this application, glue dispensing may be directly performed on the third lap joint part 142 and the third connection part 181, or the third lap joint part 142 and the third connection part 181 may be connected through another adhesive, to implement a connection between the second middle frame 140 and the second press-fitting support 180. It may be understood that the second sealing adhesive layer 143 has a specific water resistance function, and can prevent liquid from entering the entire device along a lap joint between the third lap joint part 142 and the third connection part 181.

Still refer to FIG. 7. Based on the foregoing embodiments, the second press-fitting support 180 may further have a fourth connection part 182. Correspondingly, the second middle frame 140 may have a fourth lap joint part 144 at the second opening 141. In a possible implementation, there may be a second channel 145 between the fourth connection part 182 and the fourth lap joint part 144. The second channel 145 allows the second end 112 of the flexible circuit board 110 to penetrate. In this way, the second end 112 of the flexible circuit board 110 may penetrate the second channel 145 and may be sealedly connected to the fourth connection part 182 and the fourth lap joint part 144. It may be understood that at least a part of the flexible circuit board 110 is located between the fourth lap joint part 144 and the fourth connection part 182, one surface of the second end 112 of the flexible circuit board 110 is sealedly connected to the fourth connection part 182, and the other surface of the second end 112 of the flexible circuit board 110 is sealedly connected to the fourth lap joint part 144, thereby further achieving good water resistance performance, and preventing liquid from entering the entire device along the second end 112 of the flexible circuit board 110.

Still refer to FIG. 7. Based on the foregoing embodiments, in a possible implementation, a second arc-shaped concave part 1441 may be provided on a surface that is of the fourth lap joint part 144 and that faces the fourth connection part 182, and correspondingly, the fourth connection part 182 has a second arc-shaped convex surface 1821 that protrudes toward the second arc-shaped concave part 1441. In this way, the second arc-shaped concave part 1441 can fit the second arc-shaped convex surface 1821, so that the second channel 145 in an arc shape is formed between the second arc-shaped convex surface 1821 and the second arc-shaped concave part 1441. The second end 112 of the flexible circuit board 110 penetrates the second channel 145 in the arc shape, to facilitate bending of the flexible circuit board 110 and enhance bending reliability of the flexible circuit board 110.

Still refer to FIG. 7. Based on the foregoing embodiments, the foldable electronic device 100 may further include a third sealing piece 146 and a fourth sealing piece 147. The third sealing piece 146 and the fourth sealing piece 147 are located in the second channel 145 and are far away from the hinge mechanism 120. In embodiments of this application, the third sealing piece 146 may be located between the second arc-shaped convex surface 1821 and the flexible circuit board 110, to sealedly connect the second arc-shaped convex surface 1821 and the flexible circuit board 110, so as to sealedly connect the fourth connection part 182 and the flexible circuit board 110. Correspondingly, the fourth sealing piece 147 may be located between the second arc-shaped concave part 1441 and the flexible circuit board 110, to sealedly connect the second arc-shaped concave part 1441 and the flexible circuit board 110, so as to sealedly connect the fourth lap joint part 144 and the flexible circuit board 110. In this way, disposing the third sealing piece 146 and the fourth sealing piece 147 further enhances water resistance performance of the entire device.

In embodiments of this application, the third connection part 181 of the second press-fitting support 180 is sealedly connected to the third lap joint part 142 through the second sealing adhesive layer 143, a surface that is of the fourth connection part 182 of the second press-fitting support 180 and that faces the first display 150 is sealedly connected to the flexible circuit board 110 through the third sealing piece 146, and the fourth lap joint part 144 is sealedly connected to the flexible circuit board 110 through the fourth sealing piece 147. In this way, at a specific depth and specific pressure, no liquid enters the entire device from the hinge mechanism 120, thereby preventing the liquid from entering the second channel 145 and corroding a circuit.

Still refer to FIG. 7. Based on the foregoing embodiments, second redundant space 124 that allows the flexible circuit board 110 to bend may further be provided between the fourth connection part 182 and the fourth lap joint part 144. The second redundant space 124 communicates with the second channel 145, and the second redundant space 124 may also be disposed close to the hinge mechanism 120, so that the first redundant space 123 and the second redundant space 124 are respectively located on two sides of the hinge mechanism 120. It may be understood that the second end 112 of the flexible circuit board 110 penetrates the hinge mechanism 120, and then extends out of the second channel 145 along the second redundant space 124 through the second channel 145. In the penetration process of the flexible circuit board 110, disposing the second redundant space 124 can also avoid a problem of distortion and abnormal sound when the flexible circuit board 110 is bent.

It may be understood that, a conformal design of peripheral mechanical parts such as the first middle frame 130 and the first press-fitting support 160 and the second middle frame 140 and the second press-fitting support 180 can eliminate bending abnormal sound generated in a bending process of the flexible circuit board 110, and avoid form distortion of the flexible circuit board 110, thereby ensuring that the flexible circuit board 110 can be bent in space limited by the first middle frame 130 and the first press-fitting support 160 and space limited by the second middle frame 140 and the second press-fitting support 180.

It may be further understood that the second middle frame 140 is provided with the fourth lap joint part 144 at the second opening 141, so that the flexible circuit board 110 bypasses the fourth lap joint part 144 and penetrates the second channel 145, and the flexible circuit board 110 is disposed in the bent shape. In addition, disposing the second redundant space 124 enables the flexible circuit board 110 to be bent to a greater extent. In this way, with reference to FIG. 7, the flexible circuit board 110 may be disposed in the second redundant space 124 and the second channel 145 in a bendable manner in the W shape.

Still refer to FIG. 2. Based on the foregoing embodiments, the foldable electronic device 100 may further include a battery cover 190. With reference to FIG. 1, the battery cover 190 may be located on a side that is of the second middle frame 140 and that faces away from the first display 150, and the battery cover 190 is connected to the second middle frame 140. In a possible implementation, the battery cover 190 and the second display 170 may be respectively located at two ends of the hinge mechanism 120 in the first direction. It may be understood that, when the hinge mechanism 120 is rotated to enable the foldable electronic device 100 to be in the folded state, the battery cover 190 and the second display 170 are disposed opposite to each other, and at least a part of the hinge mechanism 120 is exposed between the battery cover 190 and the second display 170. When the hinge mechanism 120 is rotated to enable the foldable electronic device 100 to be in the unfolded state, the battery cover 190 and the second display 170 may be located on a same horizontal plane, and when the battery cover 190 and the second display 170 are located on a same plane, an overall size of the battery cover 190 and the second display 170 may be the same as a size of the first display 150, so that the entire device has a good appearance.

Still refer to FIG. 7. Based on the foregoing embodiments, the foldable electronic device 100 may further include a first reinforcement part 113. The first reinforcement part 113 may be located on at least one side of the first end 111 of the flexible circuit board 110. In a possible implementation, the first reinforcement part 113 may be located between the flexible circuit board 110 and the first press-fitting support 160, and two sides of the first reinforcement part 113 can be respectively sealedly connected to the flexible circuit board 110 and the first press-fitting support 160.

Alternatively, in another possible implementation, the first reinforcement part 113 may be located between the flexible circuit board 110 and the first middle frame 130, and two sides of the first reinforcement part 113 can be respectively sealedly connected to the flexible circuit board 110 and the first middle frame 130. Certainly, in some other embodiments, there may be two first reinforcement parts 113. One first reinforcement part 113 is located between the flexible circuit board 110 and the first press-fitting support 160, and two sides of the first reinforcement part 113 are respectively sealedly connected to the flexible circuit board 110 and the first press-fitting support 160. The other first reinforcement part 113 is located between the flexible circuit board 110 and the first middle frame 130, and two sides of the first reinforcement part 113 are respectively sealedly connected to the flexible circuit board 110 and the first middle frame 130. A quantity and a position of the first reinforcement part 113 are not limited herein in embodiments of this application.

Still refer to FIG. 7. Based on the foregoing embodiments, the foldable electronic device 100 may further include a second reinforcement part 114. The second reinforcement part 114 may be located on at least one side of the second end 112 of the flexible circuit board 110. In a possible implementation, the second reinforcement part 114 may be located between the flexible circuit board 110 and the second press-fitting support 180, and two sides of the second reinforcement part 114 can be respectively sealedly connected to the flexible circuit board 110 and the second press-fitting support 180.

Alternatively, in another possible implementation, the second reinforcement part 114 may be located between the flexible circuit board 110 and the second middle frame 140, and two sides of the second reinforcement part 114 can be respectively sealedly connected to the flexible circuit board 110 and the second middle frame 140. Certainly, in some other embodiments, there may be two second reinforcement parts 114. One second reinforcement part 114 is located between the flexible circuit board 110 and the second press-fitting support 180, and two sides of the second reinforcement part 114 are respectively sealedly connected to the flexible circuit board 110 and the second press-fitting support 180. The other second reinforcement part 114 is located between the flexible circuit board 110 and the second middle frame 140, and two sides of the second reinforcement part 114 are respectively sealedly connected to the flexible circuit board 110 and the second middle frame 140. A quantity and a position of the second reinforcement part 114 are not limited herein in embodiments of this application.

It may be understood that the first reinforcement part 113 and the second reinforcement part 114 can be used to increase strength and rigidity of the flexible circuit board 110, to prevent the flexible circuit board 110 from being deformed or damaged in a use process. The first reinforcement part 113 and the second reinforcement part 114 can disperse and transfer stress, and reduce concentrated stress points, thereby prolonging a service life of the flexible circuit board 110.

Still refer to FIG. 6. Based on the foregoing embodiments, a flexible part 151 may be provided on a surface that is of the first display 150 and that faces the hinge mechanism 120, and the flexible part 151 may be formed by stacking a plurality of flexible layers, so that the flexible part 151 can be stacked on the first display 150. In a possible implementation, an area in which the flexible part 151 is located on the first display 150 may be located on a side that is of the hinge mechanism 120 and that faces the first display 150, and a front projection of the hinge mechanism 120 toward the first display 150 can cover the flexible part 151. In this way, bending reliability of the entire foldable electronic device 100 can be improved. It may be understood that the flexible part 151 may be bent or stretched similar to a bamboo-book structure. In some embodiments, the flexible part 151 may have different structures, shapes, sizes, and quantities of stacked flexible layers, and the flexible part 151 is disposed based on different requirements of the foldable electronic device 100.

Refer to FIG. 8. FIG. 8 is a diagram of a folded state of the foldable electronic device 100 according to an embodiment of this application. The first middle frame 130 and the second middle frame 140 are bent on a side that is of the hinge mechanism 120 and that faces the first display 150, so that the foldable electronic device 100 is in the folded state.

Refer to FIG. 9. Based on the foregoing embodiments, the hinge mechanism 120 may include a rotating shaft body 121 and a rotating shaft back cover 122. The rotating shaft body 121 may be located on a side that is of the rotating shaft back cover 122 and that faces the first display 150. In a possible implementation, two ends of the rotating shaft back cover 122 may be disposed toward the first display 150, and a gap that allows the flexible circuit board 110 to penetrate is provided between the rotating shaft body 121 and the rotating shaft back cover 122. One end of the rotating shaft body 121 is connected to the first middle frame 130, and the other end of the rotating shaft body 121 is connected to the second middle frame 140. It may be understood that, when the flexible circuit board 110 penetrates the two ends of the rotating shaft back cover 122, the flexible circuit board 110 can be disposed close to the first display 150, and when the flexible circuit board penetrates space between the rotating shaft back cover 122 and the rotating shaft body 121, the flexible circuit board can be disposed close to the rotating shaft back cover 122. In this way, the flexible circuit board 110 is disposed in a W shape in the hinge mechanism 120, and has good bending performance.

Based on the foregoing embodiments, the foldable electronic device 100 may further include a first housing and a second housing. The first housing includes the first middle frame 130 and the second display 170, and the second housing includes the second middle frame 140 and the battery cover 190. The first housing and the second housing are respectively located at the two ends of the hinge mechanism 120, and the first housing and the second housing are folded and unfolded by rotating the hinge mechanism 120.

It may be understood that, the groove 1341 is provided on the surface that is of the first lap joint part 134 and that faces the first display 150, so that the first lap joint part 134 and the groove 1341 form a step structure. This facilitates lap joint between the first connection part 161 and the first lap joint part 134, and further implements disposing of the first press-fitting support 160 in the first direction toward the first middle frame 130. In addition, the groove 1341 is disposed on a surface that is of the third lap joint part 142 and that faces the first display 150, so that the third lap joint part 142 and the groove 1341 form a step structure. This facilitates lap joint between the third connection part 181 and the third lap joint part 142, and further implements disposing of the second press-fitting support 180 in the first direction toward the second middle frame 140. In this way, space in the first direction can be provided for the battery inside the entire device to some extent, so that the internal structure of the foldable electronic device 100 is appropriately disposed.

Considering a stacking status of the entire foldable electronic device 100, people have different requirements for a thickness of the first housing and a thickness of the second housing in the second direction in the foldable electronic device 100. Because no display is disposed on the second housing, a thickness requirement for the second housing in the second direction is lower than a thickness requirement for the first housing in the second direction.

Refer to FIG. 9. In another possible implementation, the third connection part 181 may be located on a side that is of the third lap joint part 142 and that faces away from the first display 150, and the third connection part 181 is sealedly connected to the third lap joint part 142 through the second sealing adhesive layer 143. The groove 1341 may be provided at the position that is of the second middle frame 140 and that faces the third connection part 181, and the groove 1341 may be provided on a side that is of the third lap joint part 142 and that faces the battery cover 190. In this way, the third connection part 181 and the third lap joint part 142 can overlap and be connected in the second direction. The third lap joint part 142 fits the groove 1341 to form a step structure. This facilitates lap joint between the third connection part 181 and the third lap joint part 142.

It may be understood that, because the second housing does not relate to a light and shadow problem of a display, a surface that is of the second sealing adhesive layer 143 and that faces the battery cover 190 may be flush with or higher than a surface that is of the third lap joint part 142 and that faces the battery cover 190, and the second sealing adhesive layer 143 does not affect another component located on the second middle frame 140.

Based on a requirement for the thickness of the foldable electronic device 100 in the second direction, in another possible implementation, when an overall thickness is sufficient, the first connection part 161 may be located on a side that is of the first lap joint part 134 and that faces away from the first display 150, and the first connection part 161 is sealedly connected to the first lap joint part 134 through the first sealing adhesive layer 135. Correspondingly, the third connection part 181 may be located on the side that is of the third lap joint part 142 and that faces away from the first display 150, and the third connection part 181 is sealedly connected to the third lap joint part 142 through the second sealing adhesive layer 143. It may be understood that a surface that is of the first sealing adhesive layer 135 and that faces the second display 170 may be flush with or higher than a surface that is of the first lap joint part 134 and that faces the second display 170, and the surface that is of the second sealing adhesive layer 143 and that faces the battery cover 190 may be flush with or higher than the surface that is of the third lap joint part 142 and that faces the battery cover 190. Disposing may be performed based on an actual requirement.

A second aspect of embodiments of this application provides a bending structure. The bending structure may include the hinge mechanism 120, the first middle frame 130, and the first press-fitting support 160. The first middle frame 130 may be located on one side of the hinge mechanism 120 and is rotatably connected to the hinge mechanism 120. In a possible implementation, the first opening 133 is provided on the first middle frame 130, the first press-fitting support 160 may be located at the first opening 133, and an edge that is of the first middle frame 130 and at which the first opening 133 is provided is in lap joint with one end of the first press-fitting support 160. It may be understood that the bending structure can be used to support the flexible circuit board 110 and the first display 150 in the foregoing foldable electronic device 100.

In the descriptions of embodiments of this application, it should be noted that, unless otherwise explicitly stipulated and restricted, terms "mount", "connect to", and "connection" should be understood in a broad sense, which, for example, may be a fixed connection, or may be an indirect connection through an intermediate medium, or may be an internal connection between two elements, or may be an interaction relationship between two elements. A person of ordinary skill in the art may understand specific meanings of the foregoing terms in embodiments of this application based on specific cases.

In the specification, claims, and accompanying drawings of embodiments of this application, the terms "first", "second", "third", "fourth", and so on (if existent) are intended to distinguish between similar objects but do not necessarily indicate a specific order or sequence. It should be understood that the data termed in such a way are interchangeable in proper circumstances so that embodiments of this application described herein can be implemented in orders except the order illustrated or described herein. In addition, the terms "may include", "have", and variants thereof are intended to cover non-exclusive inclusion. For example, a process, method, system, product, or device that includes a series of steps or units is not necessarily limited to those clearly listed steps or units, but may include other steps or units that are not clearly listed or are inherent to such a process, method, product, or device.

Finally, it should be noted that the foregoing embodiments are merely used to describe the technical solutions in embodiments of this application, but not to limit the technical solutions. Although embodiments of this application are described in detail with reference to the foregoing embodiments, a person of ordinary skill in the art should understand that the technical solutions recorded in the foregoing embodiments may still be modified, or some or all of technical features thereof may be equivalently replaced. However, these modifications or replacements do not depart from the scope of the technical solutions in embodiments of this application.

## Claims

1. A foldable electronic device (100), comprising:
a flexible circuit board (110), having a first end (111) and a second end (112);
a hinge mechanism (120), wherein the flexible circuit board (110) penetrates the hinge mechanism (120) in a first direction;
a first middle frame (130), wherein the first middle frame (130) has a first side (131) and a second side (132) in a second direction, a first opening (133) is provided on the first middle frame (130), and the first opening (133) allows the first end (111) of the flexible circuit board (110) to pass through and extends through the first side (131) and the second side (132);
a second middle frame (140), wherein the first middle frame (130) and the second middle frame (140) are respectively located on two sides of the hinge mechanism (120) and are rotatably connected to the hinge mechanism (120);
a first display (150), wherein the first display (150) is located on one side of the first middle frame (130), the second middle frame (140), and the hinge mechanism, and is connected to the first middle frame (130), the second middle frame (140), and the hinge mechanism (120), and the first side (131) of the first middle frame (130) faces the first display (150); and
a first press-fitting support (160), wherein the first press-fitting support (160) is located at the first opening (133), one end of the first press-fitting support (160) has a first connection part (161), the first connection part (161) is located on the first side (131) of the first middle frame (130) and is connected to the first side (131) of the first middle frame (130), and another end of the first press-fitting support (160) fits the first middle frame (130) and is press-fitted on the flexible circuit board (110).

2. The foldable electronic device (100) according to claim 1, wherein a groove (1341) is provided at a position that is on the first side (131) of the first middle frame (130) and that faces the first connection part (161), and at least a part of the first connection part (161) is located in the groove (1341) and is in lap joint with a groove bottom of the groove (1341).

3. The foldable electronic device (100) according to claim 2, wherein the first middle frame (130) has a first lap joint part (134) close to the first opening (133), the first lap joint part (134) extends in a third direction, the groove (1341) is provided on a surface that is of the first lap joint part (134) and that faces the first display (150), the first connection part (161) of the first press-fitting support (160) is located on a side that is of the first lap joint part (134) and that faces the first display (150), and the first connection part (161) and the first lap joint part (134) overlap and are connected in the second direction.

4. The foldable electronic device (100) according to any one of claims 1 to 3, wherein the first press-fitting support (160) further has a second connection part (162); and
the first middle frame (130) has a second lap joint part (136) at the first opening (133), a first channel (137) that allows the first end (111) of the flexible circuit board (110) to penetrate is provided between the second connection part (162) and the second lap joint part (136), and the flexible circuit board (110) penetrates the first channel (137) and is sealedly connected to the second connection part (162) and the second lap joint part (136).

5. The foldable electronic device (100) according to claim 4, wherein a first arc-shaped concave part (1361) is provided on a surface that is of the second lap joint part (136) and that faces the second connection part (162), and the second connection part (162) has a first arc-shaped convex surface (1621) that protrudes toward the first arc-shaped concave part (1361); and
the first channel (137) that is in an arc shape is formed between the first arc-shaped convex surface (1621) and the first arc-shaped concave part (1361).

6. The foldable electronic device (100) according to claim 5, wherein first redundant space (123) that allows the flexible circuit board (110) to bend is provided between the second connection part (162) and the second lap joint part (136), the first redundant space (123) communicates with the first channel (137), the first redundant space (123) is close to the hinge mechanism (120), and the flexible circuit board (110) is bent in a W shape and disposed in the first redundant space (123) and the first channel (137).

7. The foldable electronic device (100) according to claim 3, further comprising a first sealing adhesive layer (135), wherein the first lap joint part (134) is sealedly connected to the first connection part (161) of the first press-fitting support (160) through the first sealing adhesive layer (135).

8. The foldable electronic device (100) according to claim 7, wherein in the second direction, a surface that is of the first sealing adhesive layer (135) and that faces the second side (132) of the first middle frame (130) is lower than a surface that is of the first lap joint part (134) and that is located on the second side (132) of the first middle frame (130).

9. The foldable electronic device (100) according to any one of claims 1 to 3, further comprising a second display (170), wherein the second display (170) is located on the second side (132) of the first middle frame (130), and the second display (170) is connected to the first middle frame (130).

10. The foldable electronic device (100) according to claim 5, further comprising a first sealing piece (138) and a second sealing piece (139), wherein the first sealing piece (138) and the second sealing piece (139) are located in the first channel (137) and are far away from the hinge mechanism (120);
the first sealing piece (138) is located between the first arc-shaped convex surface (1621) and
the flexible circuit board (110), to sealedly connect the first arc-shaped convex surface (1621) and the flexible circuit board (110); and
the second sealing piece (139) is located between the first arc-shaped concave part (1361) and the flexible circuit board (110), to sealedly connect the first arc-shaped concave part (1361) and the flexible circuit board (110).

11. The foldable electronic device (100) according to any one of claims 1 to 3, further comprising a second press-fitting support (180);
a second opening (141) that allows the second end (112) of the flexible circuit board (110) to pass through is provided on the second middle frame (140); and
the second press-fitting support (180) is located at the second opening (141), and the second press-fitting support (180) is sealedly connected to an edge of the second middle frame (140) at the second opening (141).

12. The foldable electronic device (100) according to claim 11, wherein one end of the second press-fitting support (180) has a third connection part (181), and the second middle frame (140) has a third lap joint part (142) at the second opening (141); and
the third connection part (181) is located on a side that is of the third lap joint part (142) and that faces the first display (150), and is sealedly connected to the third lap joint part (142); or
the third connection part (181) is located on a side that is of the third lap joint part (142) and that faces away from the first display (150), and is sealedly connected to the third lap joint part (142).

13. The foldable electronic device (100) according to claim 12, further comprising a second sealing adhesive layer (143), wherein the second sealing adhesive layer (143) is located between the third connection part (181) and the third lap joint part (142).

14. The foldable electronic device (100) according to claim 11, wherein the second middle frame (140) has a fourth lap joint part (144) at the second opening (141), and the second press-fitting support (180) has a fourth connection part (182); and
a second channel (145) that allows the second end (112) of the flexible circuit board (110) to penetrate is provided between the fourth connection part (182) and the fourth lap joint part (144), and the flexible circuit board (110) penetrates the second channel (145) and is sealedly connected to the fourth connection part (182) and the fourth lap joint part (144).

15. The foldable electronic device (100) according to claim 14, wherein a second arc-shaped concave part (1441) is provided on a surface that is of the fourth lap joint part (144) and that faces the fourth connection part (182), and the fourth connection part (182) has a second arc-shaped convex surface (1821) that protrudes toward the second arc-shaped concave part (1441); and
the second channel (145) that is in an arc shape is formed between the second arc-shaped convex surface (1821) and the second arc-shaped concave part (1441).

16. The foldable electronic device (100) according to claim 15, further comprising a third sealing piece (146) and a fourth sealing piece (147), wherein the third sealing piece (146) and the fourth sealing piece (147) are located in the second channel (145) and are away from the hinge mechanism (120);
the third sealing piece (146) is located between the second arc-shaped convex surface (1821) and the flexible circuit board (110), to sealedly connect the second arc-shaped convex surface (1821) and the flexible circuit board (110); and
the fourth sealing piece (147) is located between the second arc-shaped concave part (1441) and the flexible circuit board (110), to sealedly connect the second arc-shaped concave part (1441) and the flexible circuit board (110).

17. The foldable electronic device (100) according to any one of claims 14 to 16, wherein second redundant space (124) that allows the flexible circuit board (110) to bend is provided between the fourth connection part (182) and the fourth lap joint part (144), the second redundant space (124) communicates with the second channel (145), the second redundant space (124) is close to the hinge mechanism (120), and the flexible circuit board (110) is bent in a W shape and disposed in the second redundant space (124) and the second channel (145).

18. The foldable electronic device (100) according to any one of claims 1 to 3, further comprising a battery cover (190), wherein
the battery cover (190) is located on a side that is of the second middle frame (140) and that faces away from the first display (150), and the battery cover (190) is connected to the second middle frame (140).

19. The foldable electronic device (100) according to any one of claims 1 to 3, further comprising a first reinforcement part (113), wherein
the first reinforcement part (113) is located on at least one side of the first end (111) of the flexible circuit board (110), the first reinforcement part (113) is located between the flexible circuit board (110) and the first press-fitting support (160), and two sides of the first reinforcement part (113) are respectively sealedly connected to the flexible circuit board (110) and the first press-fitting support (160); or
the first reinforcement part (113) is located between the flexible circuit board (110) and the first middle frame (130), and two sides of the first reinforcement part (113) are respectively sealedly connected to the flexible circuit board (110) and the first middle frame (130).

20. The foldable electronic device (100) according to any one of claims 14 to 16, further comprising a second reinforcement part (114), wherein
the second reinforcement part (114) is located on at least one side of the second end (112) of the flexible circuit board (110), the second reinforcement part (114) is located between the flexible circuit board (110) and the second press-fitting support (180), and two sides of the second reinforcement part (114) are respectively sealedly connected to the flexible circuit board (110) and the second press-fitting support (180); or
the second reinforcement part (114) is located between the flexible circuit board (110) and the second middle frame (140), and two sides of the second reinforcement part (114) are respectively sealedly connected to the flexible circuit board (110) and the second middle frame (140).

21. The foldable electronic device according to any one of claims 1 to 3, wherein a flexible part is provided on a surface that is of the first display and that faces the hinge mechanism, and the flexible part is stacked on the first display; and
a front projection of the hinge mechanism toward the first display covers the flexible part.

22. A bending structure, comprising:
a hinge mechanism;
a first middle frame, wherein the first middle frame is located on one side of the hinge mechanism and is rotatably connected to the hinge mechanism; and
a first press-fitting support, wherein a first opening is provided on the first middle frame, the first press-fitting support is located at the first opening, and an edge that is of the first middle frame and at which the first opening is provided is in lap joint with one end of the first press-fitting support, wherein
the bending structure is configured to support a flexible circuit board and a first display.
